Europäisches Patentamt

European Patent Office

Office européen des brevets

(11) Veröffentlichungsnummer: **0 286 014**

**A2**

(12) **EUROPÄISCHE PATENTANMELDUNG**

(21) Anmeldenummer: 88105240.1

(22) Anmeldetag: 31.03.88

(51) Int. Cl.⁴ **H01L 39/14 , H01L 39/12 , H01L 39/24**

(30) Priorität: 08.04.87 DE 3711842

(43) Veröffentlichungstag der Anmeldung:
12.10.88 Patentblatt 88/41

(84) Benannte Vertragsstaaten:
**AT CH DE FR GB IT LI SE**

(71) Anmelder: **BBC Brown Boveri
Aktiengesellschaft
Kallstadter Strasse 1
D-6800 Mannheim 31(DE)**

(72) Erfinder: **Jahnke, Bernd, Dr.
Gottlob-Kammstrasse 10
D-6903 Neckargemünd(DE)**
Erfinder: **Rohr, Franz-Josef, Dr.
Forstweg 2
D-6941 Absteinach(DE)**
Erfinder: **Schmaderer, Franz
Scopiostrasse 25
D-6831 Plankstadt(DE)**
Erfinder: **Wahl, Georg, Dr.
Franz-Liszt-Strasse 9
D-6904 Eppelheim(DE)**
Erfinder: **Reich, Andy
Alstater Strasse 55
D-6900 Heidelberg(DE)**

(74) Vertreter: **Rupprecht, Klaus, Dipl.-Ing. et al
c/o BBC Brown Boveri Aktiengesellschaft
ZPT Postfach 100351 Kallstadter Strasse 1
D-6800 Mannheim 1(DE)**

(54) **Faserbündel und Verfahren zu seiner Herstellung.**

(57) Die Erfindung bezieht sich auf ein supraleitendes Faserbündel (1), dessen Trägermaterial durch Fasern (2) aus Kohlenstoff, Silizium, Carbid, Stahl, Bor oder Glas gebildet wird. Erfindungsgemäß weisen die Fasern (2) eine supraleitende Beschichtung (3) auf, die durch ein supraleitendes nichtmetallisches anorganisches Material gebildet wird. Die Beschichtung der Fasern (2) erfolgt aus der flüssigen Phase oder der Gasphase.

Fig 1

## Faserbündel und Verfahren zu seiner Herstellung

Die Erfindung bezieht sich auf ein supraleitendes Faserbündel gemäß dem Oberbegriff des Patentanspruches 1 sowie auf ein Verfahren zur Herstellung dieses Faserbündels.

Solche supraleitenden Faserbündel werden in der Energietechnik benötigt. Sie sind vor allem bei der Weiterentwicklung im Bereich der Kernfusion, der supraleitenden Generatoren sowie dem Bau von Starkfeldmagneten erforderlich. Zur Bildung von supraleitenden Faserbündeln werden einzelne Fasern aus einem metallischen oder nichtmetallischen Werkstoff mit einer supraleitenden Beschichtung überzogen.

In der Zeitschrift "Physik", Band 64, Seiten 189 bis 193, 1986 sind supraleitende Werkstoffe auf der Basis von Perovskiten und perovskitähnlichen Oxiden mit einer hohen Übergangstemperatur beschrieben.

Der Erfindung liegt die Aufgabe zugrunde, ein supraleitendes Faserbündel zu schaffen, das wenigstens bereichs weise aus supraleitenden oxidischen Werkstoffen gefertigt ist, sowie ein Verfahren zur Herstellung dieses Faserbündels aufzuzeigen.

Ein solches Faserbündel ist im Patentanspruch 1 offenbart.

Ein Verfahren zur Herstellung dieses Faserbündels ist in Patentanspruch 5 offenbart.

Durch die Beschichtung der Faseroberflächen mit supraleitenden Werkstoffen wird ein Faserbündel geschaffen, bei dem die flexiblen Eigenschaften des faserförmigen Trägermaterials erhalten bleiben. Gleichzeitig können die supraleitenden Eigenschaften der nichtmetallischen anorganischen Materialien, welche die Beschichtung bilden, optimal genutzt werden. Als besonderer Vorteil dieser supraleitenden anorganischen nichtmetallischen Werkstoffe ist ihre hohe Übergangstemperatur von über 33 K hervorzuheben. Für die Ausbildung des Faserbündels werden vorzugsweise Fasern aus Kohlenstoff, Siliziumcarbid, Bor, Stahl oder Glas verwendet. Die Beschichtung erfolgt durch chemische Abscheidung aus einer flüssigen Phase oder aus der Gasphase. Bei einer Ausführungsform des Faserbündels werden zur Verbesserung der Leitfähigkeit die Oberflächen der Fasern zunächst mit einer Zwischenschicht überzogen, die nicht notwendigerweise supraleitende Eigenschaften aufweisen muß. Vorzugsweise wird die Zwischenschicht durch wenigstens einen elektrisch leitenden keramischen oder metallischen Werkstoff gebildet. Bei einer anderen Ausführungsform des Faserbündels werden auf die Oberflächen der Fasern solche Zwischenschichten sowie supraleitende Werkstoffe alternierend aufgetragen. Es hat sich gezeigt, daß als supraleitende Werkstoffe vorzugsweise Lanthan-Strontium-Kupferoxid und Yttrium-Barium-Kupferoxid zur Ausbildung der gewünschten Faserbündel besonders geeignet sind. Unabhängig davon, ob eine Zwischenschicht verwendet wird, oder ob auf die Fasern ausschließlich supraleitende Werkstoffe aufgetragen werden, weisen die aufgetragenen Schichten immer eine Dicke auf, die kleiner gleich 10 μm ist. Die Dicke der verwendeten Fasern beträgt 5 bis 7 μm.

Die Erfindung wird nachfolgend anhand von Zeichnungen erläutert.

Es zeigen:

Figur 1: Ein erfindungsgemäßes Faserbündel im Schnitt,

Figur 2: eine einzelne Faser, ebenfalls im Schnitt.

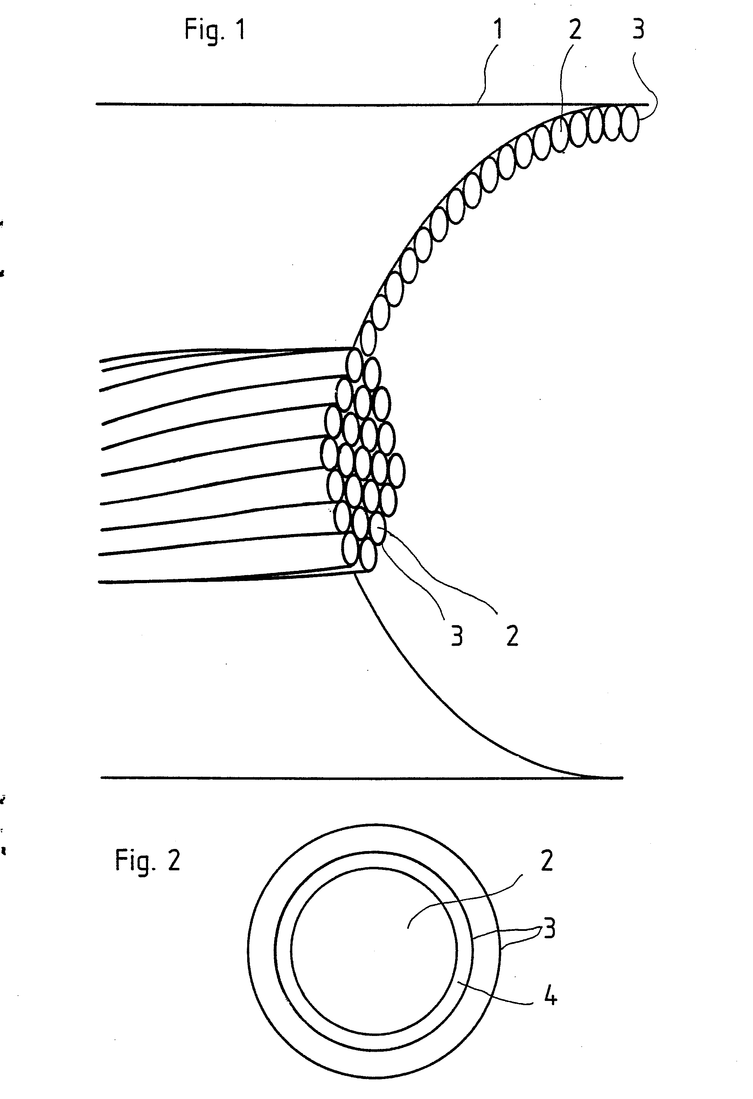

Figur 1 zeigt den Teilbereich eines Faserbündels 1, im Bereich eines Schnittes senkrecht zur Längsachse des Faserbündels 1. Wie anhand von Figur 1 zu sehen ist, wird das Faserbündel 1 aus mehreren tausend Fasern 2 gebildet, die in bekannter Weise zusammengehalten sind. Die Fasern 2 sind beispielsweise aus Siliziumcarbid, Stahl, Bor, Kohlenstoff oder Glas hergestellt. Sie weisen eine Dicke von 5 bis 7 μm auf. Andere Materialien können ebenfalls verwendet werden, soweit sie den geforderten mechanischen Anforderungen entsprechen und die notwendige Flexibilität aufweisen. Die Fasern 2 dienen als zugfeste Matrix und gleichzeitig als Substrat für den supraleitenden Werkstoff, der auf die gesamte Oberfläche der Fasern 2 aufgetragen wird. Die Beschichtung 3 wird durch Oxide und/oder Mischoxide der Elemente der 2., 3., 4., 5., 8., 9., 10., und 11. Gruppe des Periodensystems der Elemente gemäß der neuen Empfehlung der Internationalen Union für reine und angewandte Chemie, IUPAC (International Union of Pure and Applied Chemistry), gebildet. Für die Beschichtung als besonders geeignet haben sich supraleitende Werkstoffe aus Lanthan-Strontium-Kupferoxid oder Yttrium-Barium-Kupferoxid erwiesen. Um die Leitfähigkeit der Fasern 2 zu verbessern, wird die Beschichtung 3 erfindungsgemäß nicht direkt auf die Oberfläche der Fasern 2 aufgetragen. Vielmehr wird die Oberfläche der Fasern 2 zunächst mit einer Zwischenschicht 4 überzogen, die aus einem elektrisch leitenden keramischen oder metallischen Material besteht.

Figur 2 zeigt einen Schnitt durch eine Faser 2, auf deren Oberfläche zunächst eine obenbeschriebene Zwischenschicht 4 aufgetragen ist. Auf diese Zwischenschicht 4 ist anschließend die eigentliche supraleitende Beschichtung 3 aufgetragen. Erfindungsgemäß besteht die Möglichkeit, auf die Oberfläche der Fasern 2 Zwischenschichten 4 und Beschichtungen 3 alternierend aufzutragen. Das Beschichten der Fasern 2 erfolgt entweder aus der flüssigen Phase oder der Gasphase. Die Komponenten des supraleitenden Werkstoffs können in Form einer Alkoholatlösung zur Verfügung gestelllt werden, in welche die Fasern zur Beschichtung taucht werden. Ein Verdampfen des supraleitendes Materials und die Beschichtung aus der Gasphase ist ebenfalls möglich.

## Ansprüche

1. Supraleitendes Faserbündel (1), das wenigstens bereichsweise aus einem supraleitenden Werkstoff besteht und dessen Fasern (2) als Trägermaterial dienen, dadurch gekennzeichnet, daß die Oberfläche der Fasern (2) wenigstens eine Beschichtung (3) aufweist, die aus einem supraleitenden nichtmetallischen anorganischen Material gebildet ist.

2. Supraleitendes Faserbündel nach Anspruch 1, dadurch gekennzeichnet, daß die Oberfläche der Fasern (2) eine Beschichtung (3) aufweist, die aus Oxiden und/oder Mischoxiden der Elemente der 2., 3., 4., 5., 8., 9., 10. und 11. Gruppe des Periodensystems der Elemente gemäß der neuen Empfehlung der IUPAC gebildet ist.

3. Supraleitendes Faserbündel nach Anspruch 2, dadurch gekennzeichnet, daß der Sauerstoff ganz oder teilweise durch Sulfide und/oder Fluoride ersetzt ist.

4. Faserbüundel nach einem der Ansprüche 1 oder 2, dadurch gekennzeichnet, daß die als Trägermaterial dienenden Fasern (2) aus Kohlenstoff, Siliziumoxid, Metall, Bor oder Glas gefertigt sind, eine Beschichtung (3) aus Lanthan-Strontium-Kupferoxid oder Yttrium-Barium-Kupferoxid aufweisen.

5. Verfahren zur Herstellung von supraleitenden Faserbündeln (1), die wenigstens teilweise aus einem supraleitenden Werkstoff bestehen und deren Fasern (2) als Trägermaterial dienen, dadurch gekennzeichnet, daß auf die Oberfläche von Fasern (2) aus einem metallischen oder nichtmetallischen Werkstoff wenigstens eine Be schichtung (3) aus einem supraleitenden nichtmetallischen anorganischen Material aufgetragen wird.

6. Verfahren nach Anspruch 5, dadurch gekennzeichnet, daß zur Bildung des Faserbündels (1) Fasern (2) aus Kohlenstoff, Siliziumcarbid, Metall, Bor oder Glas mit einem Durchmesser von 5 bis 7 μm verwendet werden, und auf die Oberfläche der Fasern (2) eine Beschichtung (3) aus Oxiden und/oder Mischoxiden der Elemente der 2., 3., 4., 5., 8., 9., 10., und 11. Gruppe des Periodensystems der Elemente gemäß der neuen Empfehlung des IUPAC aufgetragen wird.

7. Verfahren nach Anspruch 5 oder 6, dadurch gekennzeichnet, daß auf die Oberfläche der Fasern (2) wenigstens eine Zwischenschicht (4) aus einem keramischen oder metallischen Werkstoff direkt aufgetragen wird.

8. Verfahren nach einem der Ansprüche 5 oder 6, dadurch gekennzeichnet, daß auf der Oberfläche der Fasern (2) mehrere supraleitende Schichten (3) und mehrere Zwischenschichten (4) aus einem keramischen oder metallischen Werkstoff alternierend aufgetragen werden.

9. Verfahren zur Herstellung von flexiblen supraleitenden Faserbündeln, nach einem der Ansprüche 5 oder 6, dadurch gekennzeichnet, daß die als Trägermaterial dienenden Fasern (2) mit wenigstens einer Beschichtung (3) aus Lanthan-, Strontium-, Kupferoxid oder Yttrium-Barium-Kupferoxid versehen werden.

10. Verfahren nach einem der Ansprüche 5 bis 8, dadurch gekennzeichnet, daß jedes Faserbündel (1) aus mehreren tausend Fasern gebildet wird, auf deren Ober fläche eine Beschichtung (3) mit einer Dicke von 10 μm durch chemische Abscheidung aus einer flüssigen Phase oder einer Gasphase aufgetragen wird.

Fig. 1

Fig. 2